# EUROPÄISCHE PATENTANMELDUNG

(11) **EP 4 037 136 A1**
(43) Veröffentlichungstag der Anmeldung: **03.08.2022**
(21) Anmeldenummer: 21154052.1
(22) Anmeldetag: 28.01.2021
(51) Int. Cl.: H02J 7/00, H01M 10/6563, H05K 7/20

(54) **OUTDOORBOX, SYSTEM UND VERWENDUNG EINER OUTDOORBOX UND/ODER EINES SYSTEMS**

(71) Anmelder: Andreas Stihl AG & Co. KG, 71336 Waiblingen (DE)
(72) Erfinder: KOCH, Friedhelm, 71573 Allmersbach im Tal (DE); SCHIERLING, Joana, 70736 Fellbach (DE); SCHMID-SCHÖNBEIN, Christian, 70191 Stuttgart (DE); GABLER, Simon, 71672 Marbach (DE)
(74) Vertreter: Patentanwälte Ruff, Wilhelm, Beier, Dauster & Partner mbB

(57) **Zusammenfassung**

Die Erfindung bezieht sich auf eine Outdoorbox (1),
- wobei die Outdoorbox (1) zur Aufbewahrung mindestens eines Akkupacks (2) für eine Versorgung eines elektrisch angetriebenen Garten-, Forst-, Bau- und/oder Boden-Bearbeitungsgeräts (3) mit elektrischer Antriebsleistung (AL) ausgebildet ist,
- wobei die Outdoorbox (1) mindestens zur Aufnahme mindestens eines Ladegeräts (4) zur Versorgung des Akkupacks (2) mit elektrischer Aufladeleistung (LL) ausgebildet ist,
- wobei die Outdoorbox (1) eine elektrische Leitung (5) zur Übertragung von elektrischer Leistung (eL) zu dem Ladegerät (4) aufweist,
- wobei die Outdoorbox (1) einen Austauschventilator (6) zum Austausch von Außenluft (OL) außerhalb der Outdoorbox (1) und Innenluft (IL) innerhalb der Outdoorbox (1) in Berührung mit dem Akkupack (2) und/oder dem Ladegerät (4) aufweist, und
- wobei die Outdoorbox (1) einen von dem Austauschventilator (6) verschiedenen Rezirkulierungventilator (7) zur Rezirkulierung innerhalb der Outdoorbox (1) der Innenluft (IL) aufweist, und/oder wobei die Outdoorbox (1) einen weiteren Austauschventilator (22) zum Austausch der Außenluft (OL) und der Innenluft (IL) aufweist, wobei der eine Austauschventilator (6) zur Versorgung mit elektrischer Leistung (eL) mindestens größtenteils durch eine Energiequelle (11, 12) ausgebildet ist, und wobei der weitere Austauschventilator (22) zur Versorgung mit elektrischer Leistung (eL) mindestens größtenteils durch eine von der Energiequelle (11, 12) verschiedene weitere Energiequelle (23) ausgebildet ist.

## Beschreibung

### ANWENDUNGSGEBIET UND STAND DER TECHNIK

Die Erfindung bezieht sich auf eine Outdoorbox, ein System aufweisend eine solche Outdoorbox und eine Verwendung einer solchen Outdoorbox und/oder eines solchen Systems.

### AUFGABE UND LÖSUNG

Der Erfindung liegt als Aufgabe die Bereitstellung einer Outdoorbox, die verbesserte Eigenschaften aufweist, insbesondere einen einfachen und/oder, insbesondere somit, robusten Aufbau und/oder einen einfachen und/oder unabhängigeren Betrieb der Outdoorbox, insbesondere zu einem Aufladen eines Akkupacks, ermöglicht, eines Systems aufweisend eine solche Outdoorbox und einer Verwendung einer solchen Outdoorbox und/oder eines solchen Systems zugrunde.

Die Erfindung löst die Aufgabe durch die Bereitstellung einer Outdoorbox mit den Merkmalen des Anspruchs 1, eines Systems mit den Merkmalen des Anspruchs 14 und einer Verwendung mit den Merkmalen des Anspruchs 15. Vorteilhafte Weiterbildungen und/oder Ausgestaltungen der Erfindung sind in den abhängigen Ansprüchen beschrieben.

Die erfindungsgemäße Outdoorbox ist zur Aufbewahrung mindestens eines Akkupacks für eine Versorgung eines elektrisch angetriebenen Garten-, Forst-, Bau- und/oder Boden-Bearbeitungsgeräts mit elektrischer Antriebsleistung ausgebildet bzw. konfiguriert. Des Weiteren ist die Outdoorbox mindestens zur Aufnahme mindestens eines, elektrischen, Ladegeräts zur, insbesondere automatischen, Versorgung des Akkupacks mit elektrischer Aufladeleistung ausgebildet bzw. konfiguriert. Außerdem umfasst bzw. weist die Outdoorbox eine elektrische Leitung zur, insbesondere automatischen und/oder elektrischen, Übertragung bzw. zum Transport von elektrischer Leistung zu dem Ladegerät auf. Weiter umfasst bzw. weist die Outdoorbox einen, insbesondere ersten und/oder elektrischen, Austausch- bzw. Frischluftventilator bzw. -lüfter zum, insbesondere automatischen und/oder unmittelbaren, Austausch von Außen- bzw. Frischluft außerhalb der Outdoorbox und Innenluft innerhalb der Outdoorbox in Berührung bzw., insbesondere unmittelbarem, Kontakt mit bzw. entlangströmend an dem Akkupack und/oder dem Ladegerät auf.

Zusätzlich umfasst bzw. weist die Outdoorbox einen von dem Austauschventilator verschiedenen, insbesondere elektrischen, Rezirkulierung- bzw. Umluftventilator bzw. -lüfter zur, insbesondere automatischen und/oder unmittelbaren, Rezirkulierung bzw. Umwälzung innerhalb der Outdoorbox der, insbesondere selben bzw. vorhandenen, Innenluft auf. Weiter zusätzlich oder alternativ umfasst bzw. weist die Outdoorbox einen weiteren, insbesondere zweiten und/oder elektrischen, Austauschventilator bzw. -lüfter zum, insbesondere automatischen und/oder unmittelbaren, Austausch der Außenluft und der, insbesondere selben bzw. vorhandenen, Innenluft auf. Der eine Austauschventilator ist zur, insbesondere automatischen, Versorgung bzw. die Outdoorbox ist für die Versorgung des einen Austauschventilators mit elektrischer Leistung mindestens größtenteils, insbesondere ganz bzw. vollständig bzw. nur, durch eine, insbesondere erste und/oder elektrische, Energiequelle ausgebildet bzw. konfiguriert. Der weitere Austauschventilator ist zur, insbesondere automatischen, Versorgung bzw. die Outdoorbox ist für die Versorgung des weiteren Austauschventilators mit elektrischer Leistung mindestens größtenteils, insbesondere ganz bzw. vollständig bzw. nur, durch eine von der Energiequelle, insbesondere vollständig, verschiedene weitere, insbesondere zweite und/oder elektrische, Energiequelle ausgebildet bzw. konfiguriert.

Insbesondere kann das Garten-, Forst-, Bau- und/oder Boden-Bearbeitungsgerät Umwelt- bzw. Außeneinflüssen, insbesondere Kälte und/oder Hitze und/oder Feuchte und/oder Schmutz, ausgesetzt sein.

Dies, insbesondere die Aufbewahrung des Akkupacks und/oder mindestens die Aufnahme des Ladegeräts in der Outdoorbox, ermöglicht einen Schutz des Akkupacks und/oder des Ladegeräts durch die Outdoorbox vor den Umwelteinflüssen.

Insbesondere kann die Outdoorbox den Umwelteinflüssen ausgesetzt sein.

Zusätzlich oder alternativ ermöglicht dies, insbesondere die Outdoorbox, ein, insbesondere durch die Outdoorbox vor den Umwelteinflüssen geschütztes, Aufladen des Akkupacks durch das Ladegerät.

Insbesondere kann zu dem Aufladen erforderlich bzw. notwendig sein, dass eine Innentemperatur der Innenluft, insbesondere an dem Akkupack und/oder dem Ladegerät, einen Minimaltemperaturwert erreicht und/oder überschreitet und/oder einen Maximaltemperaturwert erreicht und/oder unterschreitet. Zusätzlich oder alternativ kann das Aufladen eine Abwärme erzeugen.

Weiter zusätzlich oder alternativ ermöglicht dies, insbesondere der, insbesondere eine, Austauschventilator und der Rezirkulierungventilator und/oder der weitere Austauschventilator ermöglichen, eine, insbesondere erforderliche bzw. notwendige, Beeinflussung, insbesondere Einstellung, der Innentemperatur der Innenluft, insbesondere an dem Akkupack und/oder dem Ladegerät. Insbesondere dies durch den Austausch von, insbesondere passend, kühler Außenluft und, insbesondere unpassend, warmer bzw. heißer Innenluft, und/oder durch die Rezirkulierung der Innenluft, insbesondere mit passender Innentemperatur.

Weiter zusätzlich ermöglicht dies, insbesondere die Outdoorbox aufweisend den, insbesondere einen, Austauschventilator und den Rezirkulierungventilator, den Austausch und/oder die Rezirkulierung bzw. diese beiden, insbesondere verschiedenen, Funktionen ohne eine, insbesondere zu betreibende, Luftklappe. Zusätzlich oder alternativ ermöglicht die, insbesondere jeweilige, Versorgung durch die verschiedenen Energiequellen eine größere Betriebsbereitschaft bzw. eine größere Unabhängigkeit für den Austausch. Somit ermöglicht dies einen einfachen und/oder, insbesondere somit, robusten Aufbau und/oder einen einfachen und/oder unabhängigeren Betrieb der Outdoorbox.

Insbesondere kann die Outdoorbox eine Außen- und/oder Freiluftbox sein. Zusätzlich oder alternativ kann die Outdoorbox im Wesentlichen bzw. etwa, insbesondere genau, quaderförmig sein.

Die Outdoorbox kann zur zeitlich begrenzten Aufbewahrung bzw. zur entnehmbaren Aufbewahrung bzw. zur Entnahme mindestens des Akkupacks ausgebildet sein. Zusätzlich oder alternativ kann mindestens der Akkupack, insbesondere vollständig, in der Outdoorbox aufbewahrt bzw., insbesondere räumlich, angeordnet sein.

Der Akkupack, insbesondere entnommen bzw. nicht aufbewahrt, kann zu der Versorgung des Garten-, Forst-, Bau- und/oder Boden-Bearbeitungsgeräts mit elektrischer Antriebsleistung ausgebildet sein. Zusätzlich oder alternativ kann das Garten-, Forst-, Bau- und/oder Boden-Bearbeitungsgerät handgeführt, insbesondere handgetragen, sein. Insbesondere handgeführtes, insbesondere handgetragenes, Garten-, Forst-, Bau- und/oder Boden-Bearbeitungsgerät kann bedeuten, dass das Garten-, Forst-, Bau- und/oder Boden-Bearbeitungsgerät eine Masse von maximal 50 Kilogramm (kg), insbesondere von maximal 20 kg, insbesondere von maximal 10 kg, aufweisen bzw. haben kann. Weiter zusätzlich oder alternativ kann das Garten-, Forst-, Bau- und/oder Boden-Bearbeitungsgerät eine Säge, insbesondere eine Kettensäge, oder ein Hoch-Entaster, oder eine Heckenschere, oder ein Heckenschneider, oder ein Gehölzschneider, oder eine Astschere, oder ein Blasgerät, oder ein Laubbläser, oder ein Sauggerät, oder ein Laubsauger, oder ein Reinigungsgerät, oder ein Hochdruckreiniger, oder eine Kehrwalze, oder eine Kehrbürste, oder ein Rasenmäher, insbesondere ein Rasenmähroboter, oder ein Freischneider, oder ein Vertikutierer, oder ein Trennschleifer, oder ein Gesteinsschneider sein. Weiter zusätzlich oder alternativ kann das Garten-, Forst-, Bau- und/oder Boden-Bearbeitungsgerät einen Elektroantriebsmotor aufweisen.

Die Outdoorbox kann zur zeitlich dauerhaften Aufnahme mindestens des Ladegeräts ausgebildet sein. Zusätzlich oder alternativ kann mindestens das Ladegerät, insbesondere vollständig, in die Outdoorbox aufgenommen bzw., insbesondere räumlich, angeordnet sein.

Das Ladegerät, insbesondere aufgenommen, kann zur Versorgung des, insbesondere aufbewahrten, Akkupacks mit elektrischer Aufladeleistung ausgebildet sein.

Die elektrische Leitung kann zur Übertragung von elektrischer Leistung zu dem, insbesondere aufgenommenen, Ladegerät, insbesondere zur Versorgung des, insbesondere aufbewahrten, Akkupacks mit elektrischer Aufladeleistung durch das Ladegerät, ausgebildet sein. Zusätzlich oder alternativ kann die elektrische Leitung in die Outdoorbox, insbesondere fest, integriert sein. Weiter zusätzlich oder alternativ kann die elektrische Leitung eine Elektroinstallation sein.

Der, insbesondere eine Austauschventilator, und/oder der Rezirkulierungventilator und/oder der weitere Austauschventilator brauchen/braucht, insbesondere jeweils, nicht Teil des Ladegeräts sein. Zusätzlich oder alternativ können/kann der, insbesondere eine, Austauschventilator, und/oder der Rezirkulierungventilator und/oder der weitere Austauschventilator, insbesondere jeweils, in die Outdoorbox, insbesondere fest, integriert sein.

Die Innenluft kann in Berührung mit dem aufbewahrten Akkupack und/oder dem aufgenommenen Ladegerät sein.

Die Rezirkulierung kann von dem Austausch verschieden sein. Zusätzlich oder alternativ kann der Rezirkulierungventilator zum Austausch von der Außenluft und der Innenluft, insbesondere mit einer ausgetauschten Luft-Masse, von maximal 0,2-mal, insbesondere maximal 0,1-mal, der Rezirkulierung der Innenluft, insbesondere mit einer rezirkulierten Luft-Masse, oder sogar keinem bzw. ohne Austausch von der Außenluft und der Innenluft ausgebildet, insbesondere angeordnet und/oder ausgerichtet, sein.

Mindestens größtenteils kann mehr als 50 % (Prozent), insbesondere minimal 60 %, insbesondere minimal 70 %, insbesondere minimal 80 %, insbesondere minimal 90 %, insbesondere minimal 95 %, insbesondere minimal 99 %, der elektrischen Leistung und/oder einer Zeit bedeuten. Zusätzlich oder alternativ braucht der eine Austauschventilator nicht zur Versorgung bzw. die Outdoorbox braucht nicht zur Versorgung des einen Austauschventilators mit elektrischer Leistung durch die weitere Energiequelle ausgebildet sein. Weiter zusätzlich oder alternativ braucht der weitere Austauschventilator nicht zur Versorgung bzw. die Outdoorbox braucht nicht zur Versorgung des weiteren Austauschventilators mit elektrischer Leistung durch die eine Energiequelle ausgebildet sein. Weiter zusätzlich oder alternativ kann der Rezirkulierungventilator zur, insbesondere automatischen, Versorgung bzw. die Outdoorbox kann für die Versorgung des Rezirkulierungventilators mit elektrischer Leistung mindestens größtenteils, insbesondere ganz bzw. vollständig bzw. nur, durch die weitere Energiequelle ausgebildet sein.

Die elektrische Leitung kann zur, insbesondere automatischen und/oder elektrischen, Übertragung von elektrischer Leistung zu dem Rezirkulierungventilator und/oder dem weiteren Austauschventilator ausgebildet sein, insbesondere mit diesem/diesen, insbesondere fest, elektrisch verbunden sein. Zusätzlich oder alternativ braucht die elektrische Leitung nicht zur Übertragung von elektrischer Leistung zu dem einen Austauschventilator ausgebildet sein, insbesondere mit diesem nicht elektrisch verbunden sein.

In einer Weiterbildung der Erfindung ist die Outdoorbox als eine Transport-Outdoorbox und/oder eine mobile Outdoorbox ausgebildet bzw. konfiguriert. Zusätzlich oder alternativ ist die Outdoorbox zur Anordnung, insbesondere zur Befestigung, auf einer, insbesondere offenen, Ladefläche, insbesondere einer Pritsche, eines Fahrzeugs, insbesondere eines Kraftfahrzeugs, ausgebildet bzw. konfiguriert. Dies ermöglicht einen einfachen Transport des Akkupacks und/oder des Ladegeräts. Insbesondere kann die Outdoorbox den Umwelteinflüssen ausgesetzt sein, wenn das Fahrzeug Außen bzw. im Freien, insbesondere geparkt, ist. Zusätzlich oder alternativ kann die Outdoorbox eine Pritschenbox sein.

In einer Weiterbildung der Erfindung umfasst bzw. weist die Outdoorbox das Ladegerät auf. Insbesondere kann das Ladegerät in die Outdoorbox, insbesondere fest, integriert sein. Zusätzlich oder alternativ kann die elektrische Leitung mit dem Ladegerät, insbesondere fest, elektrisch verbunden sein. Weiter zusätzlich oder alternativ kann das Ladegerät zur, insbesondere automatischen, Versorgung bzw. die Outdoorbox kann für die Versorgung des Ladegeräts mit elektrischer Leistung mindestens größtenteils, insbesondere ganz bzw. vollständig bzw. nur, durch die weitere Energiequelle ausgebildet sein.

In einer Weiterbildung der Erfindung umfasst bzw. weist die elektrische Leitung einen Elektrizitätsnetzanschluss, insbesondere einen Netzstecker, auf. Insbesondere ist die elektrische Leitung zur, insbesondere automatischen und/oder elektrischen, Übertragung bzw. zum Transport von elektrischer Leistung von dem Elektrizitätsanschluss zu dem Rezirkulierungventilator und/oder dem weiteren Austauschventilator ausgebildet bzw. konfiguriert. Dies ermöglicht eine Versorgung mit elektrischer Leistung aus einem externen, insbesondere öffentlichen, Stromnetz. Insbesondere kann das externe Stromnetz die weitere Energiequelle aufweisen, insbesondere sein. Zusätzlich oder alternativ kann das Stromnetz ein Niederspannungsnetz, insbesondere von 100 Volt (V) bis 1000 V, insbesondere von 100 V bis 127 V oder 220 V bis 240 V oder 400 V, sein. Weiter zusätzlich oder alternativ kann der Elektrizitätsanschluss ein Niederspannungs-Elektrizitätsanschluss, insbesondere ein 100 V bis 127 V und/oder 220 V bis 240 V oder 400 V-Elektrizitätsanschluss, sein.

In einer Weiterbildung der Erfindung umfasst bzw. weist die Outdoorbox eine, insbesondere direkte und/oder elektrische, Strahlungsenergie-Umwandlungs-Einrichtung, insbesondere eine Solarzelle, zur, insbesondere automatischen, Versorgung, insbesondere zum, insbesondere automatischen, Betrieb, des, insbesondere einen, Austauschventilators, insbesondere unabhängig bzw. ungesteuert und/oder ungeregelt von einer Innentemperatur, insbesondere eines Werts der Innentemperatur, der Innenluft und/oder einer Außentemperatur, insbesondere eines Werts der Außentemperatur, der Außenluft, mit elektrischer Leistung auf. Dies ermöglicht bei Strahlung, insbesondere bei Solar- bzw. Sonnenstrahlung, und in der Regel somit bei der, insbesondere unpassend, warmen bzw. heißen Innenluft den Austausch der, insbesondere passend, kühlen Außenluft und der, insbesondere unpassend, warmen bzw. heißen Innenluft. Insbesondere ermöglicht dies einen besonderes einfachen und/oder, insbesondere somit, besonders robusten Aufbau der Outdoorbox. Insbesondere kann die eine Energiequelle die Strahlungsenergie-Umwandlungs-Einrichtung aufweisen, insbesondere sein. Zusätzlich oder alternativ kann die Strahlungsenergie-Umwandlungs-Einrichtung eine Solarenergie-Umwandlungs-Einrichtung sein. Weiter zusätzlich oder alternativ kann die Strahlungsenergie-Umwandlungs-Einrichtung mit dem Austauschventilator, insbesondere fest, elektrisch verbunden sein. Weiter zusätzlich oder alternativ kann der, insbesondere eine, Austauschventilator ein Solarlüfter sein. Weiter zusätzlich oder alternativ kann die Strahlungsenergie-Umwandlungs-Einrichtung in die Outdoorbox, insbesondere fest, integriert sein.

In einer Weiterbildung, insbesondere einer Ausgestaltung, der Erfindung umfasst bzw. weist die Outdoorbox einen elektrischen Energiespeicher, insbesondere eine Batterie, zur, insbesondere automatischen, Versorgung, insbesondere zum, insbesondere automatischen, Betrieb, des, insbesondere einen, Austauschventilators, insbesondere unabhängig bzw. ungesteuert und/oder ungeregelt von einer Innentemperatur, insbesondere einem Wert der Innentemperatur, der Innenluft und/oder einer Außentemperatur, insbesondere einem Wert der Außentemperatur, der Außenluft, mit elektrischer Leistung, insbesondere von der Strahlungsenergie-Umwandlungs-Einrichtung, soweit vorhanden, auf. Dies ermöglicht eine besonders größere Betriebsbereitschaft bzw. eine besonders größere Unabhängigkeit für den Austausch, insbesondere wenn die Sonne verdeckt ist oder sogar nicht scheint. Insbesondere ermöglicht dies einen besonders einfachen und/oder, insbesondere somit, besonders robusten Aufbau der Outdoorbox. Insbesondere kann die eine Energiequelle den elektrischen Energiespeicher aufweisen, insbesondere sein. Zusätzlich oder alternativ kann der elektrische Energiespeicher aufladbar, insbesondere ausgebildet sein. Weiter zusätzlich oder alternativ kann der elektrische Energiespeicher zur Speisung von dem, insbesondere einen, Austauschventilator nicht benötigter elektrischer Leistung durch die Strahlungsenergie-Umwandlungs-Einrichtung ausgebildet sein, insbesondere bei viel Strahlung. Des Weiteren kann der elektrische Energiespeicher zur Speisung bzw. Abgabe von dem, insbesondere einen, Austauschventilator benötigter elektrischer Leistung ausgebildet sein, insbesondere bei wenig oder sogar keiner Strahlung. Weiter zusätzlich oder alternativ kann die Batterie mit dem, insbesondere einen, Austauschventilator, insbesondere und der Strahlungsenergie-Umwandlungs-Einrichtung, insbesondere fest, elektrisch verbunden sein. Weiter zusätzlich oder alternativ kann der elektrische Energiespeicher ein Zwischenspeicher sein. Weiter zusätzlich oder alternativ kann der elektrische Energiespeicher in die Outdoorbox, insbesondere fest, integriert sein.

In einer Weiterbildung, insbesondere einer Ausgestaltung, der Erfindung umfasst bzw. weist die Outdoorbox einen Boxbehälter bzw. -körper und einen Boxdeckel auf. Der Boxbehälter ist zur Aufbewahrung des Akkupacks und mindestens zur Aufnahme des Ladegeräts ausgebildet bzw. konfiguriert. Insbesondere sind/ist an dem Boxbehälter die elektrische Leitung und/oder der Rezirkulierungventilator und/oder der weitere Austauschventilator, insbesondere unmittelbar, angeordnet, insbesondere befestigt. Der Boxdeckel ist zum Öffnen und Schließen, insbesondere Verschließen, des Boxbehälters gegenüber diesem beweglich, insbesondere ausgebildet, insbesondere durch einen Menschen bzw. Benutzer. An dem Boxdeckel ist, insbesondere sind, der, insbesondere eine, Austauschventilator, insbesondere und die Strahlungsenergie-Umwandlungs-Einrichtung und/oder der elektrische Energiespeicher, soweit vorhanden, insbesondere unmittelbar, angeordnet, insbesondere befestigt. Dies ermöglicht die Aufbewahrung, insbesondere und die Entnahme, des Akkupacks und/oder die Aufnahme des Ladegeräts, insbesondere bei geöffnetem bzw. nicht geschlossenem Boxbehälter. Zusätzlich oder alternativ ermöglicht dies, dass die elektrische Leitung nicht von dem Boxbehälter zu dem Boxdeckel führen braucht. Insbesondere kann der Boxdeckel mittels eines Scharniers an dem Boxbehälter beweglich angeordnet, insbesondere befestigt sein. Zusätzlich oder alternativ können/kann das Ladegerät und/oder die elektrische Leitung und/oder der Rezirkulierungventilator und/oder der weitere Austauschventilator, insbesondere jeweils, in den Boxbehälter, insbesondere fest, integriert sein. Weiter zusätzlich oder alternativ können/kann der, insbesondere eine, Austauschventilator und/oder die Strahlungsenergie-Umwandlungs-Einrichtung und/oder der elektrische Energiespeicher, insbesondere jeweils, in den Boxdeckel, insbesondere fest, integriert sein.

In einer Weiterbildung, insbesondere einer Ausgestaltung, der Erfindung hat bzw. umfasst bzw. weist die Outdoorbox mindestens eine Lufteinlassöffnung zum Einlass der Außenluft in die Outdoorbox hinein und mindestens eine Luftauslassöffnung zum Auslass der Innenluft aus der Outdoorbox heraus auf. Die Luftauslassöffnung ist in Bezug auf die Lufteinlassöffnung in einer Vertikalrichtung von einer Unterseite zu einer Oberseite der Outdoorbox oberhalb, insbesondere und in einer Horizontalrichtung orthogonal zu der Vertikalrichtung versetzt, insbesondere angeordnet, insbesondere bei bestimmungsgemäßer Ausrichtung bzw. Stellung bzw. Lage der Outdoorbox und/oder bei geschlossener Outdoorbox. Insbesondere ist die Luftauslassöffnung an, insbesondere in, der Oberseite, insbesondere dem Boxdeckel, soweit vorhanden, insbesondere angeordnet. Zusätzlich oder alternativ ist die Lufteinlassöffnung an, insbesondere in, der Unterseite und/oder einer Umfangsseite der Outdoorbox, insbesondere dem Boxbehälter, soweit vorhanden, insbesondere angeordnet. Dies ermöglicht einen besonders guten Austausch der, insbesondere warmen bzw. heißen, Innenluft, insbesondere und eine Strömung der Innenluft mindestens teilweise in der Horizontalrichtung. Insbesondere können/kann die Lufteinlassöffnung und/oder die Luftauslassöffnung, insbesondere jeweils, durch eine Richtung einer Luft-Strömung, insbesondere gefördert durch den, insbesondere einen, Austauschventilator und/oder den weiteren Austauschventilator, definiert sein. Zusätzlich oder alternativ kann die Oberseite der Unterseite gegenüberliegend sein. Weiter zusätzlich oder alternativ kann die Umfangsseite der Unterseite und/oder der Oberseite, insbesondere jeweils, abgewandt sein und/oder, insbesondere in der Vertikalrichtung, zwischen der Unterseite und der Oberseite sein.

In einer Weiterbildung der Erfindung hat bzw. umfasst bzw. weist die Outdoorbox mindestens eine, insbesondere die, Lufteinlassöffnung zum Einlass der Außenluft in die Outdoorbox hinein und/oder mindestens eine, insbesondere die, Luftauslassöffnung zum Auslass der Innenluft aus der Outdoorbox heraus auf. Die Outdoorbox ist zur Aufbewahrung des Akkupacks und/oder mindestens zur Aufnahme des Ladegeräts in Bezug auf die Lufteinlassöffnung und/oder die Luftauslassöffnung in einer, insbesondere der, Vertikalrichtung von einer, insbesondere der, Unterseite zu einer, insbesondere der, Oberseite der Outdoorbox oberhalb und/oder in einer, insbesondere der, Horizontalrichtung orthogonal zu der Vertikalrichtung versetzt ausgebildet bzw. konfiguriert, insbesondere bei bestimmungsgemäßer Ausrichtung bzw. Stellung bzw. Lage der Outdoorbox und/oder bei geschlossener Outdoorbox. Dies ermöglicht einen besonders guten Schutz des Akkupacks und/oder des Ladegeräts durch die Outdoorbox vor den Umwelteinflüssen, insbesondere vor Feuchte und/oder Schmutz. Insbesondere können/kann die Lufteinlassöffnung und/oder die Luftauslassöffnung, insbesondere jeweils, durch eine Richtung einer Luft-Strömung, insbesondere gefördert durch den, insbesondere einen, Austauschventilator und/oder den weiteren Austauschventilator, definiert sein. Zusätzlich oder alternativ kann die Oberseite der Unterseite gegenüberliegend sein. Weiter zusätzlich oder alternativ können/kann die Lufteinlassöffnung und/oder die Luftauslassöffnung sich, insbesondere jeweils, im Wesentlichen bzw. etwa, insbesondere genau, in der Horizontalrichtung erstrecken.

In einer Weiterbildung der Erfindung hat bzw. umfasst bzw. weist die Outdoorbox mindestens eine, insbesondere die, Lufteinlassöffnung zum Einlass der Außenluft in die Outdoorbox hinein und/oder mindestens eine, insbesondere die, Luftauslassöffnung zum Auslass der Innenluft aus der Outdoorbox heraus auf. Der, insbesondere eine, Austauschventilator und/oder der weitere Austauschventilator sind/ist an, insbesondere in, der Lufteinlassöffnung oder der Luftauslassöffnung, insbesondere angeordnet, und haben/hat bzw. weisen/weist einen, insbesondere jeweiligen, Austauschabstand entlang eines, insbesondere jeweiligen, Luft-Strömungs-Wegs von dieser, insbesondere nächsten, auf. Ein Rezirkulierungabstand, insbesondere ein Wert des Rezirkulierungsabstands, des Rezirkulierungventilators entlang eines, insbesondere eigenen, Luft-Strömungs-Wegs ist von der, insbesondere nächsten, Lufteinlassöffnung und/oder der, insbesondere nächsten, Luftauslassöffnung größer als der Austauschabstand, insbesondere der Wert des Austauschabstands, insbesondere bei geschlossener Outdoorbox. Dies ermöglicht den Austausch und die Rezirkulierung bzw. diese beiden, insbesondere verschiedenen, Funktionen. Insbesondere können/kann die Lufteinlassöffnung und/oder die Luftauslassöffnung, insbesondere jeweils, durch eine Richtung einer Luft-Strömung, insbesondere gefördert durch den, insbesondere einen, Austauschventilator und/oder den weiteren Austauschventilator, definiert sein. Zusätzlich oder alternativ kann der Austauschabstand Null sein.

In einer Weiterbildung der Erfindung ist der, insbesondere eine, Austauschventilator zur Förderung bzw. Erzeugung einer Luft-Strömung, insbesondere in dem Austauschventilator, im Wesentlichen bzw. etwa, insbesondere genau, in einer ersten Richtung, insbesondere einer, insbesondere der, Vertikalrichtung von einer, insbesondere der, Unterseite zu einer, insbesondere der, Oberseite der Outdoorbox ausgerichtet, insbesondere bei bestimmungsgemäßer Ausrichtung bzw. Stellung bzw. Lage der Outdoorbox und/oder bei geschlossener Outdoorbox. Zusätzlich oder alternativ ist der Rezirkulierungventilator zur Förderung bzw. Erzeugung einer Luft-Strömung, insbesondere in dem Rezirkulierungventilator, im Wesentlichen bzw. etwa, insbesondere genau, in einer zweiten Richtung, insbesondere einer, insbesondere der, Horizontalrichtung und/oder verschieden von, insbesondere orthogonal zu, der ersten Richtung, ausgerichtet, insbesondere bei bestimmungsgemäßer Ausrichtung bzw. Stellung bzw. Lage der Outdoorbox und/oder bei geschlossener Outdoorbox. Weiter zusätzlich oder alternativ ist der weitere Austauschventilator zur Förderung bzw. Erzeugung einer Luft-Strömung, insbesondere in dem Austauschventilator, im Wesentlichen bzw. etwa, insbesondere genau, in einer dritten Richtung, insbesondere einer, insbesondere weiteren, Horizontalrichtung und/oder verschieden von, insbesondere orthogonal zu, der ersten Richtung und/oder der zweiten Richtung, ausgerichtet, insbesondere bei bestimmungsgemäßer Ausrichtung bzw. Stellung bzw. Lage der Outdoorbox und/oder bei geschlossener Outdoorbox. Dies ermöglicht den Austausch und die Rezirkulierung bzw. diese beiden, insbesondere verschiedenen, Funktionen und/oder einen besonders guten Austausch durch den einen Austauschventilator und den weiteren Austauschventilator. Insbesondere können/kann der, insbesondere eine, Austauschventilator, der Rezirkulierungventilator und/oder der weitere Austauschventilator, insbesondere jeweils, ein Axialventilator sein, wobei eine, insbesondere jeweilige, Axialrichtung des, insbesondere jeweiligen, Axialventilators im Wesentlichen, insbesondere genau, in der, insbesondere ersten, zweiten oder dritten, Richtung sein kann. Zusätzlich oder alternativ kann im Wesentlichen maximal 30 ° (Grad), insbesondere maximal 20 °, insbesondere maximal 10 °, von der, insbesondere ersten, zweiten oder dritten, Richtung abweichend bedeuten.

In einer Weiterbildung der Erfindung umfasst bzw. weist die Outdoorbox einen, insbesondere elektrischen, Heizer, insbesondere einen Radiator, und/oder einen, insbesondere elektrischen, Kühler, insbesondere ein Peltier-Element, auf. Der Rezirkulierungventilator bzw. die Outdoorbox ist zur, insbesondere automatischen und/oder unmittelbaren, Rezirkulierung der Innenluft an dem Heizer und/oder dem Kühler entlang, insbesondere entlangströmend, ausgebildet bzw. konfiguriert. Dies ermöglicht ein energieeffizientes Erwärmen und/oder Abkühlen der Innenluft, insbesondere da durch die Rezirkulierung mit wenig oder sogar keinem Austausch der Innenluft. Insbesondere können/kann der Heizer und/oder der Kühler, insbesondere jeweils, zur, insbesondere automatischen, Versorgung bzw. die Outdoorbox kann für die Versorgung des Heizers und/oder des Kühlers, insbesondere jeweils, mit elektrischer Leistung mindestens größtenteils, insbesondere ganz bzw. vollständig bzw. nur, durch die weitere Energiequelle ausgebildet sein. Zusätzlich oder alternativ kann die elektrische Leitung zur, insbesondere automatischen und/oder elektrischen, Übertragung von elektrischer Leistung zu dem Heizer und/oder dem Kühler, insbesondere jeweils, ausgebildet sein, insbesondere mit diesen/diesem, insbesondere fest, elektrisch verbunden sein. Weiter zusätzlich oder alternativ können/kann der Heizer und/oder der Kühler, insbesondere jeweils, in die Outdoorbox, insbesondere fest, integriert sein.

In einer Weiterbildung, insbesondere einer Ausgestaltung, der Erfindung umfasst bzw. weist die Outdoorbox eine, insbesondere elektrische, Steuer- und/oder Regeleinrichtung zum, insbesondere automatischen, Steuern und/oder Regeln eines, insbesondere jeweiligen, Betriebs des Rezirkulierungventilators, insbesondere und des Heizers und/oder des Kühlers, soweit vorhanden, und/oder des weiteren Austauschventilators abhängig von einer, insbesondere der, Innentemperatur, insbesondere eines Werts der Innentemperatur, insbesondere erfasst mittels eines, insbesondere elektrischen, Innentemperatursensors der Outdoorbox, der Innenluft und/oder einer, insbesondere der, Außentemperatur, insbesondere eines Werts der Außentemperatur, insbesondere erfasst mittels eines, insbesondere elektrischen, Außentemperatursensors der Outdoorbox, der Außenluft auf. Insbesondere derart, dass die Innentemperatur einen, insbesondere den, Minimaltemperaturwert erreicht und/oder überschreitet und/oder einen, insbesondere den, Maximaltemperaturwert erreicht und/oder unterschreitet. Dies ermöglicht eine besonders gute Beeinflussung, insbesondere Einstellung, insbesondere der Innentemperatur. Insbesondere kann die Steuer- und/oder Regeleinrichtung mit dem Rezirkulierungventilator, dem Heizer, dem Kühler, dem weiteren Austauschventilator, dem Innentemperatursensor und/oder dem Außentemperatursensor elektrisch verbunden sein. Zusätzlich oder alternativ kann die Steuer- und/oder Regeleinrichtung zur, insbesondere automatischen, Versorgung bzw. die Outdoorbox kann für die Versorgung der Steuer- und/oder Regeleinrichtung mit elektrischer Leistung mindestens größtenteils, insbesondere ganz bzw. vollständig bzw. nur, durch die weitere Energiequelle ausgebildet sein. Weiter zusätzlich oder alternativ kann die elektrische Leitung zur, insbesondere automatischen und/oder elektrischen, Übertragung von elektrischer Leistung zu der Steuer- und/oder Regeleinrichtung ausgebildet sein, insbesondere mit dieser, insbesondere fest, elektrisch verbunden sein. Weiter zusätzlich oder alternativ können/kann die Steuer- und/oder Regeleinrichtung, der Innentemperatursensor und/oder der Außentemperatursensor, insbesondere jeweils, in die Outdoorbox, insbesondere fest, integriert sein.

Das erfindungsgemäße System umfasst bzw. weist eine, insbesondere die, Outdoorbox wie vorhergehend genannt und den Akkupack und/oder das Ladegerät und/oder das Garten-, Forst-, Bau- und/oder Boden-Bearbeitungsgerät und/oder das Fahrzeug auf.

Die erfindungsgemäße Verwendung ist eine, insbesondere automatische, Verwendung einer, insbesondere der, Outdoorbox wie vorhergehend genannt und/oder eines, insbesondere des, Systems wie vorhergehend genannt zur, insbesondere automatischen, Versorgung des, insbesondere aufbewahrten, Akkupacks mit elektrischer Aufladeleistung durch das, insbesondere aufgenommene, Ladegerät. Die Verwendung kann einen Teil oder sogar alle der Vorteile wie vorhergehend für die Outdoorbox ermöglichen.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgenden anhand der Figuren erläutert sind. Dabei zeigen:
- Fig. 1: eine schematische Schnittansicht einer erfindungsgemäßen Outdoorbox und eine erfindungsgemäße Verwendung der Outdoorbox,
- Fig. 2: eine weitere schematische Schnittansicht der Outdoorbox der Fig. 1,
- Fig. 3: eine schematische Perspektivansicht eines erfindungsgemäßen Systems aufweisend die Outdoorbox der Fig. 1 und einer erfindungsgemäße Verwendung der Outdoorbox und/oder des Systems, insbesondere bei geschlossener Outdoorbox,
- Fig. 4: eine weitere schematische Perspektivansicht des Systems der Fig. 3, insbesondere bei geöffneter Outdoorbox,
- Fig. 5: schematische zeitliche Verläufe einer Innentemperatur einer Innenluft und eines Ladezustands eines Akkupacks bei einer nicht-erfindungsgemäßen, Verwendung einer nicht-erfindungsgemäßen, Outdoorbox, insbesondere bei einer kalten Außentemperatur einer Außenluft,
- Fig. 6: weitere schematische zeitliche Verläufe einer Innentemperatur einer Innenluft und eines Ladezustands eines Akkupacks bei der erfindungsgemäßen, insbesondere Verwendung der erfindungsgemäßen, Outdoorbox der Fig. 1, insbesondere bei einer kalten Außentemperatur einer Außenluft,
- Fig. 7: weitere schematische zeitliche Verläufe einer Innentemperatur einer Innenluft und eines Ladezustands eines Akkupacks bei einer nicht-erfindungsgemäßen, Verwendung einer nicht-erfindungsgemäßen, Outdoorbox, insbesondere bei einer warmen Außentemperatur einer Außenluft, und
- Fig. 8: weitere schematische zeitliche Verläufe einer Innentemperatur einer Innenluft und eines Ladezustands eines Akkupacks bei der erfindungsgemäßen, insbesondere Verwendung der erfindungsgemäßen, Outdoorbox der Fig. 1, insbesondere bei einer warmen Außentemperatur einer Außenluft.

### DETAILLIERTE BESCHREIBUNG DER AUSFÜHRUNGSBEISPIELE

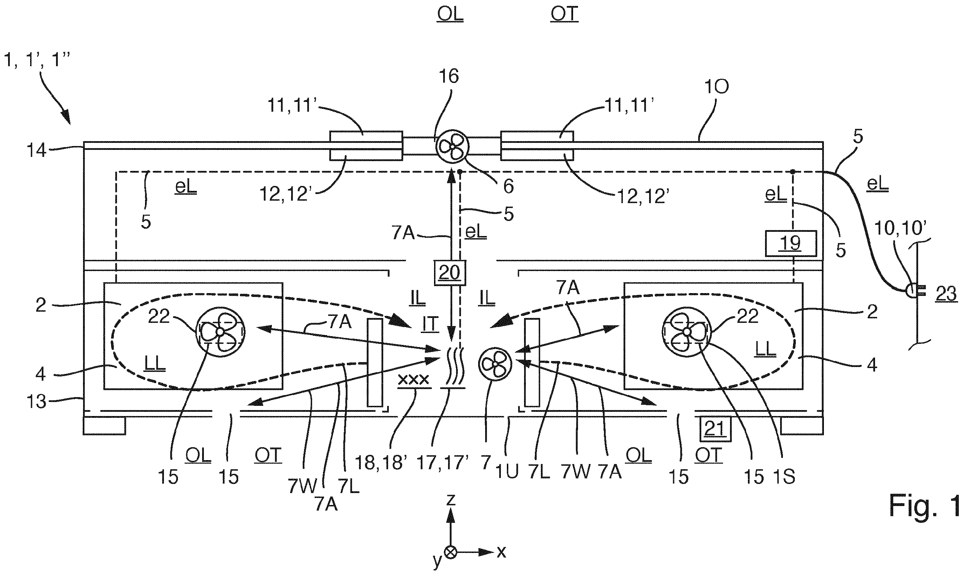

Fig. 1 bis 4 zeigen eine erfindungsgemäße Outdoorbox 1. Die Outdoorbox 1 ist zur Aufbewahrung mindestens eines Akkupacks 2 für eine Versorgung eines elektrisch angetriebenen Garten-, Forst-, Bau- und/oder Boden-Bearbeitungsgeräts 3 mit elektrischer Antriebsleistung AL ausgebildet, insbesondere bewahrt auf. Des Weiteren ist die Outdoorbox 1 mindestens zur Aufnahme mindestens eines Ladegeräts 4 zur Versorgung des Akkupacks mit elektrischer Aufladeleistung LL ausgebildet, insbesondere nimmt auf. Außerdem weist die Outdoorbox 1 eine elektrische Leitung 5 zur Übertragung von elektrischer Leistung eL zu dem Ladegerät 4 auf. Weiter weist die Outdoorbox 1 einen Austauschventilator 6 zum Austausch von Außenluft OL außerhalb der Outdoorbox 1 und Innenluft IL innerhalb der Outdoorbox 1 in Berührung mit dem Akkupack 2 und/oder dem Ladegerät 4 auf.

Zusätzlich weist die Outdoorbox 1 einen von dem Austauschventilator 6 verschiedenen Rezirkulierungventilator 7 zur Rezirkulierung innerhalb der Outdoorbox 1 der Innenluft IL auf.

Weiter zusätzlich oder alternativ weist die Outdoorbox 1 einen weiteren Austauschventilator 22 zum Austausch der Außenluft OL und der Innenluft IL auf. Der eine Austauschventilator 6 ist zur Versorgung mit elektrischer Leistung eL mindestens größtenteils durch eine Energiequelle 11, 12 ausgebildet. Der weitere Austauschventilator 22 ist zur Versorgung mit elektrischer Leistung eL mindestens größtenteils durch eine von der Energiequelle 11, 12 verschiedene weitere Energiequelle 23 ausgebildet.

In alternativen Ausführungsbeispielen kann die Outdoorbox zusätzlich zu dem, insbesondere einen, Austauschventilator entweder den Rezirkulierungventilator oder den weiteren Austauschventilator aufweisen. Insbesondere falls die Outdoorbox zusätzlich zu dem Austauschventilator, insbesondere nur, den Rezirkulierungventilator aufweist, können der Austauschventilator und der Rezirkulierungventilator zur Versorgung mit elektrischer Leistung mindestens größtenteils durch die, insbesondere selbe, Energiequelle ausgebildet sein.

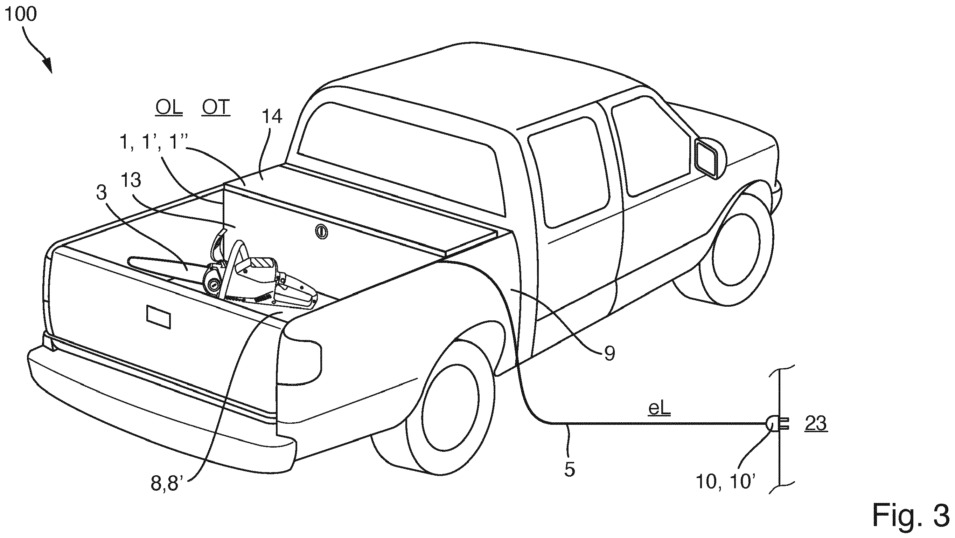

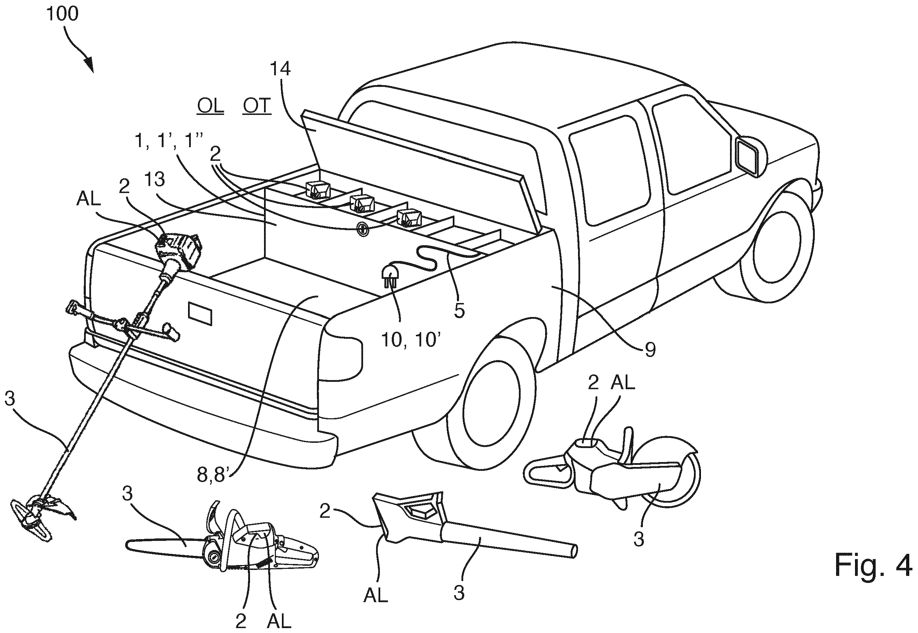

Des Weiteren zeigen Fig. 3 und 4 ein erfindungsgemäßes System 100. Das System 100 weist die Outdoorbox 1 und den Akkupack 2 und/oder das Ladegerät 4 und/oder das Garten-, Forst-, Bau- und/oder Boden-Bearbeitungsgerät 3 und/oder ein Fahrzeug 9 auf.

Außerdem zeigen Fig. 1 und 3 eine erfindungsgemäße Verwendung der Outdoorbox 1 und/oder des Systems 100 zur Versorgung des, insbesondere aufbewahrten, Akkupacks 2 mit elektrischer Aufladeleistung LL durch das, insbesondere aufgenommene, Ladegerät 4.

Im Detail ist die Outdoorbox 1 als eine Transport-Outdoorbox 1' und/oder eine mobile Outdoorbox 1" ausgebildet.

Zusätzlich oder alternativ ist die Outdoorbox zur Anordnung, insbesondere zur Befestigung, auf einer, insbesondere offenen, Ladefläche 8, insbesondere einer Pritsche 8', des Fahrzeugs 9 ausgebildet, insbesondere angeordnet, insbesondere befestigt.

Weiter weist die Outdoorbox 1 das Ladegerät 4 auf.

Zudem weist die elektrische Leitung 5 einen Elektrizitätsnetzanschluss 10, insbesondere einen Netzstecker 10', auf.

In dem gezeigten Ausführungsbeispiel weist ein externes Stromnetz die weitere Energiequelle 23 auf.

Des Weiteren weist die Outdoorbox 1 eine, insbesondere direkte, Strahlungsenergie-Umwandlungs-Einrichtung 11, insbesondere eine Solarzelle 11', zur Versorgung, insbesondere zum Betrieb, des, insbesondere einen, Austauschventilators 6, insbesondere unabhängig von einer Innentemperatur IT der Innenluft IL und/oder einer Außentemperatur OT der Außenluft OL, mit elektrischer Leistung eL auf.

In alternativen Ausführungsbeispielen braucht die Outdoorbox nicht die Strahlungsenergie-Umwandlungs-Einrichtung aufweisen.

Außerdem weist die Outdoorbox 1 einen elektrischen Energiespeicher 12, insbesondere eine Batterie 12', zur Versorgung, insbesondere zum Betrieb, des, insbesondere einen, Austauschventilators 6, insbesondere unabhängig von der Innentemperatur IT der Innenluft IL und/oder der Außentemperatur OT der Außenluft OL, mit elektrischer Leistung eL, insbesondere von der Strahlungsenergie-Umwandlungs-Einrichtung 11, auf.

In alternativen Ausführungsbeispielen braucht die Outdoorbox nicht den elektrischen Energiespeicher aufweisen.

In dem gezeigten Ausführungsbeispiel weist die eine Energiequelle 11, 12 die Strahlungsenergie-Umwandlungs-Einrichtung 11 und/oder den elektrischen Energiespeicher 12 auf.

Weiter weist die Outdoorbox 1 einen Boxbehälter 13 und einen Boxdeckel 14 auf. Der Boxbehälter 13 ist zur Aufbewahrung des Akkupacks 2 und mindestens zur Aufnahme des Ladegeräts 4 ausgebildet, insbesondere bewahrt auf und nimmt auf. Insbesondere sind/ist an dem Boxbehälter 13 die elektrische Leitung 5 und/oder der Rezirkulierungventilator 7 und/oder der weitere Austauschventilator 22 angeordnet, insbesondere befestigt. Der Boxdeckel 14 ist zum Öffnen und Schließen des Boxbehälters 13 gegenüber diesem beweglich. An dem Boxdeckel 14 ist, insbesondere sind, der, insbesondere eine, Austauschventilator 6, insbesondere und die Strahlungsenergie-Umwandlungs-Einrichtung 11 und/oder der elektrische Energiespeicher 12, angeordnet, insbesondere befestigt.

In alternativen Ausführungsbeispielen braucht die Outdoorbox nicht einen Boxdeckel aufweisen. Zusätzlich oder alternativ kann in alternativen Ausführungsbeispielen die Outdoorbox mindestens eine Boxtür, insbesondere an einer Umfangsseite der Outdoorbox, insbesondere des Boxehälters, aufweisen, wobei die Boxtür zum Öffnen und Schließen des Boxbehälters gegenüber diesem beweglich, insbesondere ausgebildet, sein kann. Weiter zusätzlich oder alternativ kann/können in alternativen Ausführungsbeispielen der, insbesondere eine, Austauschventilator, insbesondere und die Strahlungsenergie-Umwandlungs-Einrichtung und/oder der elektrische Energiespeicher, insbesondere soweit vorhanden, an dem Boxbehälter, insbesondere an einer Oberseite, insbesondere der Outdoorbox, angeordnet, insbesondere befestigt, sein.

Zudem weist die Outdoorbox 1 mindestens eine Lufteinlassöffnung 15 zum Einlass der Außenluft OL in die Outdoorbox 1 hinein und/oder mindestens eine Luftauslassöffnung 16 zum Auslass der Innenluft IL aus der Outdoorbox 1 heraus auf.

Zusätzlich ist die Luftauslassöffnung 16 in Bezug auf die Lufteinlassöffnung 15 in einer Vertikalrichtung z von einer Unterseite 1U zu einer Oberseite 1O der Outdoorbox 1 oberhalb, insbesondere und in einer Horizontalrichtung x orthogonal zu der Vertikalrichtung z versetzt. Insbesondere ist die Luftauslassöffnung 16 an, insbesondere in, der Oberseite 1O, insbesondere dem Boxdeckel 14 Zusätzlich oder alternativ ist die Lufteinlassöffnung 15 an, insbesondere in, der Unterseite 1U und/oder einer Umfangsseite 1S der Outdoorbox 1, insbesondere dem Boxbehälter 13.

Weiter zusätzlich oder alternativ ist die Outdoorbox 1 zur Aufbewahrung des Akkupacks 2 und/oder mindestens zur Aufnahme des Ladegeräts 4 in Bezug auf die Lufteinlassöffnung 15 und/oder die Luftauslassöffnung 16 in der Vertikalrichtung z von der Unterseite 1U zu der Oberseite 1O der Outdoorbox 1 oberhalb und/oder in der Horizontalrichtung x orthogonal zu der Vertikalrichtung z versetzt ausgebildet, insbesondere bewahrt auf und/oder nimmt auf.

Weiter zusätzlich oder alternativ sind/ist der, insbesondere eine, Austauschventilator 6 und/oder der weitere Austauschventilator 22 an, insbesondere in, der Lufteinlassöffnung 15 oder der Luftauslassöffnung 16 weisen/weist einen, insbesondere jeweiligen, Austauschabstand 6A, 22A entlang eines, insbesondere jeweiligen, Luft-Strömungs-Wegs 6W, 22W von dieser auf. Ein Rezirkulierungabstand 7A des Rezirkulierungventilators 7 entlang eines, insbesondere eigenen, Luft-Strömungs-Wegs 7W ist von der Lufteinlassöffnung 15 und/oder der Luftauslassöffnung 16 größer als der Austauschabstand 6A, 22A.

Des Weiteren ist der, insbesondere eine, Austauschventilator 6 zur Förderung einer Luft-Strömung 6L, im Wesentlichen, insbesondere genau, in einer ersten Richtung z, insbesondere der Vertikalrichtung z von der Unterseite 1U zu der Oberseite 1O der Outdoorbox 1 ausgerichtet, insbesondere fördert. Zusätzlich oder alternativ ist der Rezirkulierungventilator 7 zur Förderung einer Luft-Strömung, 7L im Wesentlichen, insbesondere genau, in einer zweiten Richtung x, insbesondere der Horizontalrichtung x und/oder verschieden von, insbesondere orthogonal zu, der ersten Richtung z, ausgerichtet, insbesondere fördert. Weiter zusätzlich oder alternativ ist der weitere Austauschventilator 22 zur Förderung einer Luft-Strömung 22L im Wesentlichen, insbesondere genau, in einer dritten Richtung y, insbesondere einer, insbesondere weiteren, Horizontalrichtung y und/oder verschieden von, insbesondere orthogonal zu, der ersten Richtung x und/oder der zweiten Richtung z, ausgerichtet, insbesondere fördert.

In alternativen Ausführungsbeispielen können/kann der, insbesondere eine, Austauschventilator, der Rezirkulierungventilator und/oder der weitere Austauschventilator, insbesondere jeweils, in eine andere Richtung fördern.

Zusätzlich oder alternativ braucht in alternativen Ausführungsbeispielen der, insbesondere eine, Austauschventilator nicht an der Oberseite angeordnet sein. Insbesondere kann der, insbesondere eine, Austauschventilator an der Umfangsseite angeordnet sein.

Außerdem weist die Outdoorbox 1 einen Heizer 17, insbesondere einen Radiator 17', und/oder einen Kühler 18, insbesondere ein Peltier-Element 18', auf. Der Rezirkulierungventilator 7 ist zur Rezirkulierung der Innenluft IL an dem Heizer 17 und/oder dem Kühler 18 entlang ausgebildet.

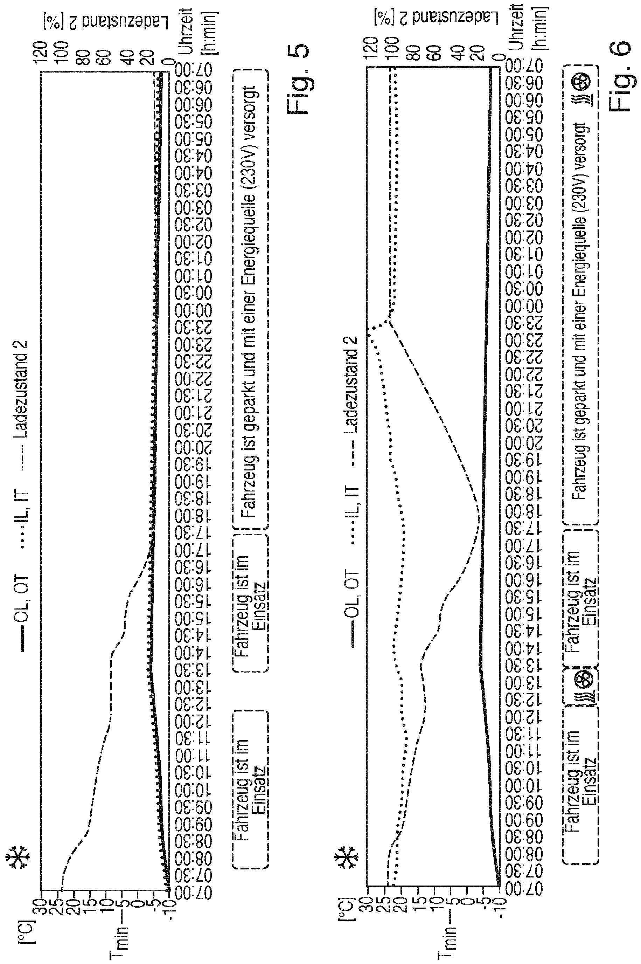

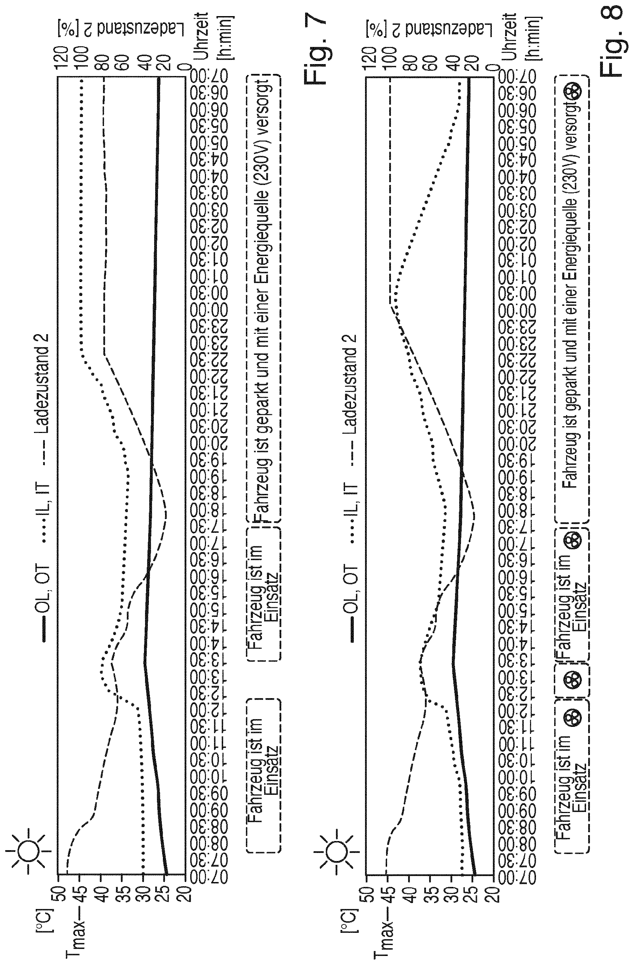

Zudem weist die Outdoorbox 1 eine Steuer- und/oder Regeleinrichtung 19 zum Steuern und/oder Regeln eines, insbesondere jeweiligen, Betriebs des Rezirkulierungventilators 7, insbesondere und des Heizers 17 und/oder des Kühlers 18, und/oder des weiteren Austauschventilators 22 abhängig von der Innentemperatur IT, insbesondere erfasst mittels eines Innentemperatursensors 20 der Outdoorbox 1, der Innenluft IL und/oder der Außentemperatur OT, insbesondere erfasst mittels eines Außentemperatursensors 21 der Outdoorbox 1, der Außenluft OL auf. Insbesondere derart, dass die Innentemperatur IT einen Minimaltemperaturwert Tmin erreicht und/oder überschreitet und/oder einen Maximaltemperaturwert Tmax erreicht und/oder unterschreitet, wie in Fig. 6 und 8 gezeigt.

In dem gezeigten Ausführungsbeispiel sind/ist das Ladegerät 4 und/oder der Rezirkulierungventilator 7 und/oder der Heizer 17 und/oder der Kühler 18 und/oder die Steuer- und/oder Regeleinrichtung 19, insbesondere jeweils, zur Versorgung mit elektrischer Leistung eL mindestens größtenteils durch die weitere Energiequelle 23 ausgebildet.

Des Weiteren ist in dem gezeigten Ausführungsbeispiel die elektrische Leitung 5 zur Übertragung von elektrischer Leistung eL von dem Elektrizitätsanschluss 10 zu dem Ladegerät 4 und/oder dem Rezirkulierungventilator 7 und/oder dem weiteren Austauschventilator 22 und/oder dem Heizer 17 und/oder dem Kühler 18 und/oder der Steuer- und/oder Regeleinrichtung 19 ausgebildet.

In Fig. 1 und 3 überträgt die elektrische Leitung 5 elektrische Leistung eL, insbesondere von dem Elektrizitätsanschluss 10, zu dem Ladegerät 4 und/oder dem Rezirkulierungventilator 7 und/oder dem weiteren Austauschventilator 22 und/oder dem Heizer 17 und/oder dem Kühler 18 und/oder der Steuer- und/oder Regeleinrichtung 19.

In Fig. 1 und 3 werden/wird das Ladegerät 4 und/oder der Rezirkulierungventilator 7 und/oder der Heizer 17 und/oder der Kühler 18 und/oder die Steuer- und/oder Regeleinrichtung 19 mit elektrischer Leistung eL durch die weitere Energiequelle 23 versorgt.

Nicht gezeigt ist, wie der weitere Austauschventilator 22 mit elektrischer Leistung eL durch die weitere Energiequelle 23 versorgt wird.

In Fig. 1 rezirkuliert der Rezirkulierungventilator 7 die Innenluft IL, insbesondere an dem Heizer 17 und/oder dem Kühler 18 entlang.

Nicht gezeigt ist, wie der weitere Austauschventilator 22 die Außenluft OL und die Innenluft IL austauscht.

In Fig. 1 versorgt das, insbesondere aufgenommene, Ladegerät 4 den, insbesondere aufbewahrten, Akkupack 2 mit elektrischer Aufladeleistung LL.

In Fig. 4 versorgt der Akkupack 2, insbesondere entnommen bzw. nicht aufbewahrt, das Garten-, Forst-, Bau- und/oder Boden-Bearbeitungsgerät 3 mit elektrischer Antriebsleistung AL.

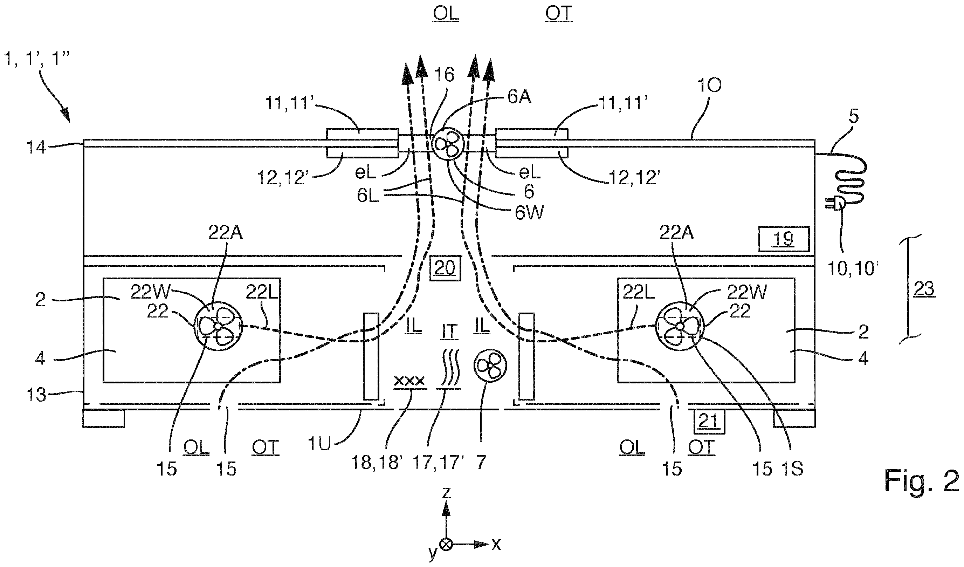

In Fig. 2 wird der eine Austauschventilator 6 mit elektrischer Leistung eL durch die eine Energiequelle 11, 12, insbesondere die Strahlungsenergie-Umwandlungs-Einrichtung 11 und/oder den elektrischen Energiespeicher 12, versorgt, insbesondere betrieben.

In Fig. 2 tauscht der Austauschventilator 6 die Außenluft OL und die Innenluft IL aus.

Fig. 5 zeigt schematische zeitliche Verläufe einer Innentemperatur IT einer Innenluft IL und eines Ladezustands eines Akkupacks 2 bei einer nicht-erfindungsgemäßen, Verwendung einer nicht-erfindungsgemäßen, Outdoorbox, insbesondere bei einer kalten Außentemperatur OT einer Außenluft OL. Von Morgen bis Abend ist das Fahrzeug im Einsatz. Somit sinkt der Ladezustand des Akkupacks 2. Von Abend bis, insbesondere nächsten, Morgen ist das Fahrzeug geparkt und durch eine, insbesondere weitere, Energiequelle 23 versorgt. Aber die Innentemperatur IT der Innenluft IL unterschreitet den Minimaltemperaturwert Tmin, insbesondere von 5 ° C (Grad Celsius). Somit ist ein Aufladen des Akkupacks 2 nicht möglich. Somit steigt der Ladezustand des Akkupacks 2 nicht.

Fig. 6 zeigt weitere schematische zeitliche Verläufe der Innentemperatur IT der Innenluft IL und des Ladezustands des Akkupacks 2 bei der erfindungsgemäßen, insbesondere Verwendung der erfindungsgemäßen, Outdoorbox 1, insbesondere bei der kalten Außentemperatur OT der Außenluft OL. Von Morgen bis Mittag und von Mittag bis Abend ist das Fahrzeug 9 im Einsatz. Somit sinkt der Ladezustand des Akkupacks 2. Mittags und von Abend bis, insbesondere nächsten, Morgen ist das Fahrzeug 9 geparkt und durch die, insbesondere weitere, Energiequelle 23 versorgt. Der Rezirkulierungventilator 7 ermöglicht, insbesondere und der, insbesondere heizende, Heizer 17 und/oder nicht der Austauschventilator 6 ermöglichen, dass die Innentemperatur IT den Minimaltemperaturwert Tmin erreicht und/oder überschreitet, insbesondere gesteuert und/oder geregelt durch die Steuer- und/oder Regeleinrichtung 19. Somit ist ein, insbesondere vollständiges, Aufladen des Akkupacks 2 möglich. Somit steigt der Ladezustand des Akkupacks 2, insbesondere vollständig.

Fig. 7 zeigt weitere schematische zeitliche Verläufe einer Innentemperatur IT einer Innenluft IL und eines Ladezustands eines Akkupacks 2 bei einer nicht-erfindungsgemäßen, Verwendung einer nicht-erfindungsgemäßen, Outdoorbox, insbesondere bei einer warmen Außentemperatur OT einer Außenluft OL. Von Morgen bis Abend ist das Fahrzeug im Einsatz. Somit sinkt der Ladezustand des Akkupacks 2. Von Abend bis, insbesondere nächsten, Morgen ist das Fahrzeug geparkt und durch eine, insbesondere weitere, Energiequelle 23 versorgt. Aber die Innentemperatur IT der Innenluft IL überschreitet den Maximaltemperaturwert Tmax, insbesondere von 45 ° C, insbesondere beim Aufladen des Akkupacks 2. Somit ist ein vollständiges Aufladen des Akkupacks 2 nicht möglich. Somit steigt der Ladezustand des Akkupacks 2 nicht vollständig.

Fig. 8 zeigt weitere schematische zeitliche Verläufe der Innentemperatur IT der Innenluft IL und des Ladezustands des Akkupacks 2 bei der erfindungsgemäßen, insbesondere Verwendung der erfindungsgemäßen, Outdoorbox 1, insbesondere bei der warmen Außentemperatur OT der Außenluft OL. Von Morgen bis Mittag und von Mittag bis Abend ist das Fahrzeug 9 im Einsatz. Somit sinkt der Ladezustand des Akkupacks 2. Mittags und von Abend bis, insbesondere nächsten, Morgen ist das Fahrzeug 9 geparkt und durch die, insbesondere weitere, Energiequelle 23 versorgt. Der eine Austauschventilator 6 ermöglicht, insbesondere von Morgen bis Abend, und/oder der Rezirkulierungventilator 7 und/oder der weitere Austauschventilator 22, insbesondere und der, insbesondere kühlende, Kühler 18, ermöglichen/ermöglicht, insbesondere von Abend bis, insbesondere nächsten, Morgen, dass die Innentemperatur IT den Maximaltemperaturwert Tmax erreicht und/oder unterschreitet und oder eine Vermeidung oder sogar eine Verhinderung eines Hitzestaus in der Outdoorbox 1, insbesondere gesteuert und/oder geregelt durch die Steuer- und/oder Regeleinrichtung 19. Somit ist ein, insbesondere vollständiges, Aufladen des Akkupacks 2 möglich. Somit steigt der Ladezustand des Akkupacks 2, insbesondere vollständig.

Im Übrigen ist die Outdoorbox 1, insbesondere an ihrer Oberseite 1O und/oder ihrer Umfangsseite 1S, thermisch isoliert. Dies ermöglicht eine Stabilität der Innentemperatur IT der Innenluft IL.

Zusätzlich oder alternativ kann die Outdoorbox zur Aufbewahrung von mindestens zwei, insbesondere mindestens fünf, insbesondere mindestens zehn, insbesondere mindestens zwanzig, und/oder maximal hundert, insbesondere maximal fünfzig, insbesondere achtundzwanzig, Akkupacks ausgebildet sein. Weiter zusätzlich oder alternativ kann die Outdoorbox mindestens zur Aufnahme von mindestens zwei, insbesondere mindestens fünf, und/oder maximal zwanzig, insbesondere maximal zehn, insbesondere sieben, Ladegeräten ausgebildet sein. Weiter zusätzlich oder alternativ kann das Ladegerät ein Mehrfachladegerät sein.

Weiter zusätzlich oder alternativ kann die Outdoorbox minimal 50 cm (Zentimeter), insbesondere minimal 100 cm, und/oder maximal 400 cm, insbesondere maximal 300 cm, insbesondere 193 cm, breit, insbesondere in der Horizontalrichtung x, und/oder minimal 25 cm, insbesondere minimal 50 cm, und/oder maximal 200 cm, insbesondere maximal 100 cm, insbesondere 65 cm, tief, insbesondere in der Horizontalrichtung y, und/oder minimal 25 cm, insbesondere minimal 50 cm, und/oder maximal 200 cm, insbesondere maximal 100 cm, insbesondere 75 cm, hoch, insbesondere in der Vertikalrichtung z, sein.

Wie die gezeigten und oben erläuterten Ausführungsbeispiele deutlich machen, stellt die Erfindung eine vorteilhafte Outdoorbox, die verbesserte Eigenschaften aufweist, insbesondere einen einfachen und/oder, insbesondere somit, robusten Aufbau und/oder einen einfachen und/oder unabhängigeren Betrieb der Outdoorbox, insbesondere zu einem Aufladen eines Akkupacks, ermöglicht, ein vorteilhaftes System aufweisend eine solche Outdoorbox und eine vorteilhafte Verwendung einer solchen Outdoorbox und/oder eines solchen Systems bereit.

## Patentansprüche

1. Outdoorbox (1),
- wobei die Outdoorbox (1) zur Aufbewahrung mindestens eines Akkupacks (2) für eine Versorgung eines elektrisch angetriebenen Garten-, Forst-, Bau- und/oder Boden-Bearbeitungsgeräts (3) mit elektrischer Antriebsleistung (AL) ausgebildet ist,
- wobei die Outdoorbox (1) mindestens zur Aufnahme mindestens eines Ladegeräts (4) zur Versorgung des Akkupacks (2) mit elektrischer Aufladeleistung (LL) ausgebildet ist,
- wobei die Outdoorbox (1) eine elektrische Leitung (5) zur Übertragung von elektrischer Leistung (eL) zu dem Ladegerät (4) aufweist,
- wobei die Outdoorbox (1) einen Austauschventilator (6) zum Austausch von Außenluft (OL) außerhalb der Outdoorbox (1) und Innenluft (IL) innerhalb der Outdoorbox (1) in Berührung mit dem Akkupack (2) und/oder dem Ladegerät (4) aufweist, und
- wobei die Outdoorbox (1) einen von dem Austauschventilator (6) verschiedenen Rezirkulierungventilator (7) zur Rezirkulierung innerhalb der Outdoorbox (1) der Innenluft (IL) aufweist, und/oder wobei die Outdoorbox (1) einen weiteren Austauschventilator (22) zum Austausch der Außenluft (OL) und der Innenluft (IL) aufweist, wobei der eine Austauschventilator (6) zur Versorgung mit elektrischer Leistung (eL) mindestens größtenteils durch eine Energiequelle (11, 12) ausgebildet ist, und wobei der weitere Austauschventilator (22) zur Versorgung mit elektrischer Leistung (eL) mindestens größtenteils durch eine von der Energiequelle (11, 12) verschiedene weitere Energiequelle (23) ausgebildet ist.

2. Outdoorbox (1) nach Anspruch 1,
- wobei die Outdoorbox (1) als eine Transport-Outdoorbox (1') und/oder eine mobile Outdoorbox (1") ausgebildet ist, und/oder
- wobei die Outdoorbox (1) zur Anordnung, insbesondere zur Befestigung, auf einer, insbesondere offenen, Ladefläche (8), insbesondere einer Pritsche (8'), eines Fahrzeugs (9) ausgebildet ist.

3. Outdoorbox (1) nach einem der vorhergehenden Ansprüche,
- wobei die Outdoorbox (1) das Ladegerät (4) aufweist.

4. Outdoorbox (1) nach einem der vorhergehenden Ansprüche,
- wobei die elektrische Leitung (5) einen Elektrizitätsnetzanschluss (10), insbesondere einen Netzstecker (10'), aufweist,
- insbesondere wobei die elektrische Leitung (5) zur Übertragung von elektrischer Leistung (eL) von dem Elektrizitätsanschluss (10) zu dem Rezirkulierungventilator (7) und/oder dem weiteren Austauschventilator (22) ausgebildet ist.

5. Outdoorbox (1) nach einem der vorhergehenden Ansprüche,
- wobei die Outdoorbox (1) eine, insbesondere direkte, Strahlungsenergie-Umwandlungs-Einrichtung (11), insbesondere eine Solarzelle (11'), zur Versorgung, insbesondere zum Betrieb, des, insbesondere einen, Austauschventilators (6), insbesondere unabhängig von einer Innentemperatur (IT) der Innenluft (IL) und/oder einer Außentemperatur (OT) der Außenluft (OL), mit elektrischer Leistung (eL) aufweist.

6. Outdoorbox (1) nach einem der vorhergehenden Ansprüche, insbesondere nach Anspruch 5,
- wobei die Outdoorbox (1) einen elektrischen Energiespeicher (12), insbesondere eine Batterie (12'), zur Versorgung, insbesondere zum Betrieb, des, insbesondere einen, Austauschventilators (6), insbesondere unabhängig von einer Innentemperatur (IT) der Innenluft (IL) und/oder einer Außentemperatur (OT) der Außenluft (OL), mit elektrischer Leistung (eL), insbesondere von der Strahlungsenergie-Umwandlungs-Einrichtung (11), aufweist.

7. Outdoorbox (1) nach einem der vorhergehenden Ansprüche, insbesondere nach Anspruch 5 und/oder 6,
- wobei die Outdoorbox (1) einen Boxbehälter (13) und einen Boxdeckel (14) aufweist,
- wobei der Boxbehälter (13) zur Aufbewahrung des Akkupacks (2) und mindestens zur Aufnahme des Ladegeräts (4) ausgebildet ist, insbesondere und wobei an dem Boxbehälter (13) die elektrische Leitung (5) und/oder der Rezirkulierungventilator (7) und/oder der weitere Austauschventilator (22) angeordnet, insbesondere befestigt, sind/ist,
- wobei der Boxdeckel (14) zum Öffnen und Schließen des Boxbehälters (13) gegenüber diesem beweglich ist, und wobei an dem Boxdeckel (14) der, insbesondere eine, Austauschventilator (6), insbesondere und die Strahlungsenergie-Umwandlungs-Einrichtung (11) und/oder der elektrische Energiespeicher (12), angeordnet, insbesondere befestigt, ist, insbesondere sind.

8. Outdoorbox (1) nach einem der vorhergehenden Ansprüche, insbesondere nach Anspruch 7,
- wobei die Outdoorbox (1) mindestens eine Lufteinlassöffnung (15) zum Einlass der Außenluft (OL) in die Outdoorbox (1) hinein und mindestens eine Luftauslassöffnung (16) zum Auslass der Innenluft (IL) aus der Outdoorbox (1) heraus aufweist, wobei die Luftauslassöffnung (16) in Bezug auf die Lufteinlassöffnung (15) in einer Vertikalrichtung (z) von einer Unterseite (1U) zu einer Oberseite (1O) der Outdoorbox (1) oberhalb, insbesondere und in einer Horizontalrichtung (x) orthogonal zu der Vertikalrichtung (z) versetzt, ist,
- insbesondere wobei die Luftauslassöffnung (16) an, insbesondere in, der Oberseite (1O), insbesondere dem Boxdeckel (14), ist, und/oder wobei die Lufteinlassöffnung (15) an, insbesondere in, der Unterseite (1U) und/oder einer Umfangsseite (1S) der Outdoorbox (1), insbesondere dem Boxbehälter (13), ist.

9. Outdoorbox (1) nach einem der vorhergehenden Ansprüche,
- wobei die Outdoorbox (1) mindestens eine Lufteinlassöffnung (15) zum Einlass der Außenluft (OL) in die Outdoorbox (1) hinein und/oder mindestens eine Luftauslassöffnung (16) zum Auslass der Innenluft (IL) aus der Outdoorbox (1) heraus aufweist, und
- wobei die Outdoorbox (1) zur Aufbewahrung des Akkupacks (2) und/oder mindestens zur Aufnahme des Ladegeräts (4) in Bezug auf die Lufteinlassöffnung (15) und/oder die Luftauslassöffnung (16) in einer Vertikalrichtung (z) von einer Unterseite (1U) zu einer Oberseite (1O) der Outdoorbox (1) oberhalb und/oder in einer Horizontalrichtung (x) orthogonal zu der Vertikalrichtung (z) versetzt ausgebildet ist.

10. Outdoorbox (1) nach einem der vorhergehenden Ansprüche,
- wobei die Outdoorbox (1) mindestens eine Lufteinlassöffnung (15) zum Einlass der Außenluft (OL) in die Outdoorbox (1) hinein und/oder mindestens eine Luftauslassöffnung (16) zum Auslass der Innenluft (IL) aus der Outdoorbox (1) heraus aufweist,
- wobei der, insbesondere eine, Austauschventilator (6) und/oder der weitere Austauschventilator (22) an, insbesondere in, der Lufteinlassöffnung (15) oder der Luftauslassöffnung (16) sind/ist und einen Austauschabstand (6A, 22A) entlang eines Luft-Strömungs-Wegs (6W, 22W) von dieser aufweisen/aufweist, und
- wobei ein Rezirkulierungabstand (7A) des Rezirkulierungventilators (7) entlang eines Luft-Strömungs-Wegs (7W) von der Lufteinlassöffnung (15) und/oder der Luftauslassöffnung (16) größer als der Austauschabstand (6A, 22A) ist.

11. Outdoorbox (1) nach einem der vorhergehenden Ansprüche,
- wobei der, insbesondere eine, Austauschventilator (6) zur Förderung einer Luft-Strömung (6L) im Wesentlichen in einer ersten Richtung (z), insbesondere einer Vertikalrichtung (z) von einer Unterseite (1U) zu einer Oberseite (1O) der Outdoorbox (1), ausgerichtet ist, und/oder
- wobei der Rezirkulierungventilator (7) zur Förderung einer Luft-Strömung (7L) im Wesentlichen in einer zweiten Richtung (x), insbesondere einer Horizontalrichtung (x) und/oder verschieden von, insbesondere orthogonal zu, der ersten Richtung (z), ausgerichtet ist, und/oder
- wobei der weitere Austauschventilator (22) zur Förderung einer Luft-Strömung (22L) im Wesentlichen in einer dritten Richtung (y), insbesondere einer, insbesondere weiteren, Horizontalrichtung (y) und/oder verschieden von, insbesondere orthogonal zu, der ersten Richtung (z) und/oder der zweiten Richtung (x), ausgerichtet ist.

12. Outdoorbox (1) nach einem der vorhergehenden Ansprüche,
- wobei die Outdoorbox (1) einen Heizer (17), insbesondere einen Radiator (17'), und/oder einen Kühler (18), insbesondere ein Peltier-Element (18'), aufweist, und
- wobei der Rezirkulierungventilator (7) zur Rezirkulierung der Innenluft (IL) an dem Heizer (17) und/oder dem Kühler (18) entlang ausgebildet ist.

13. Outdoorbox (1) nach einem der vorhergehenden Ansprüche, insbesondere nach Anspruch 12,
- wobei die Outdoorbox (1) eine Steuer- und/oder Regeleinrichtung (19) zum Steuern und/oder Regeln eines Betriebs des Rezirkulierungventilators (7), insbesondere und des Heizers (17) und/oder des Kühlers (18), und/oder des weiteren Austauschventilators (22) abhängig von einer Innentemperatur (IT), insbesondere erfasst mittels eines Innentemperatursensors (20) der Outdoorbox (1), der Innenluft (IL) und/oder einer Außentemperatur (OT), insbesondere erfasst mittels eines Außentemperatursensors (21) der Outdoorbox (1), der Außenluft (OL) aufweist,
- insbesondere derart, dass die Innentemperatur (IT) einen Minimaltemperaturwert (Tmin) erreicht und/oder überschreitet und/oder einen Maximaltemperaturwert (Tmax) erreicht und/oder unterschreitet.

14. System (100), wobei das System (100) aufweist:
- eine Outdoorbox (1) nach einem der vorhergehenden Ansprüche, insbesondere nach Anspruch 2, und
- den Akkupack (2) und/oder das Ladegerät (4) und/oder das Garten-, Forst-, Bau- und/oder Boden-Bearbeitungsgerät (3) und/oder das Fahrzeug (9).

15. Verwendung einer Outdoorbox (1) nach einem der Ansprüche 1 bis 13 und/oder eines Systems (100) nach Anspruch 14 zur Versorgung des Akkupacks (2) mit elektrischer Aufladeleistung (LL) durch das Ladegerät (4).
